# EUROPEAN PATENT APPLICATION

(11) **EP 2 858 464 A1**
(43) Date of publication of application: **08.04.2015**
(21) Application number: 13187221.0
(22) Date of filing: 03.10.2013
(51) Int. Cl.: H05K 1/02, H05K 7/20, H05K 1/18

(54) **Electric apparatus**

(71) Applicant: ABB Oy, 00380 Helsinki (FI)
(72) Inventor: Huesgen, Till, 87545 Burgberg (DE); Kearney, Daniel, 5405 Baden-Daettwil (CH); Malinowski, Lukasz, 31-038 Krakow (PL)
(74) Representative: Kolster Oy Ab

(57) **Abstract**

The invention relates to an electric apparatus, comprising: a circuit board (1), and a cooling element (11) for dissipating heat. In order to provide an efficient cooling, the circuit board (1) comprises a fluid channel (7) for passing fluid to a condenser section (6) which is thermally connected to the cooling element (11), and the circuit board (1) comprises an evaporator section (5) for receiving a heat load from one or more electric components (4, 8) and for passing the heat load to a fluid in the fluid channel (7).

## Description

### BACKGROUND OF THE INVENTION

### FIELD OF THE INVENTION

This invention relates to an electric apparatus and more particularly to a solution for providing adequate cooling for an electric component of an electric apparatus.

### DESCRIPTION OF PRIOR ART

Previously there is known an electric apparatus with a circuit board having an electric component. A problem with such a solution is that the electric component generates heat during use.

In order to avoid that the heat generated by the electric component raises the temperature to an extent where the electric component or other components of the electric apparatus is damaged, this known electric apparatus is provided with a cooling element.

The cooling element may be arranged to contact a surface of the circuit board or a surface of the electric component in order to ensure that adequate cooling is achieved. However, such an arrangement requires additional devices in the apparatus in immediate vicinity of the circuit board and/or the electric component, which increases the size of the apparatus and also the number of components needed.

### SUMMARY OF THE INVENTION

An object of the present invention is to solve the above mentioned drawback and to provide a simple and efficient solution for providing adequate cooling for an electric apparatus. This object is achieved with an electric apparatus according to independent claim 1.

The use of a circuit board with a cooling channel and an evaporator section receiving a het load from one or more electric components and passing the received heat load to a fluid in the fluid channel, makes it possible to obtain an apparatus with an efficient cooling, a compact design and a relatively small number of components.

Preferred embodiments are disclosed in the dependent claims.

### BRIEF DESCRIPTION OF DRAWINGS

In the following the present invention will be described in closer detail by way of example and with reference to the attached drawings, in which

Figures 1 to 3 illustrate a first embodiment of an electric apparatus,

Figures 4 to 6 illustrate a second embodiment of an electric apparatus,

Figures 7 to 8 illustrate a third embodiment of an electric apparatus,
Figure 9 illustrates a fourth embodiment of an electric apparatus, and

Figure 10 illustrates manufacturing of a circuit board.

### DESCRIPTION OF AT LEAST ONE EMBODIMENT

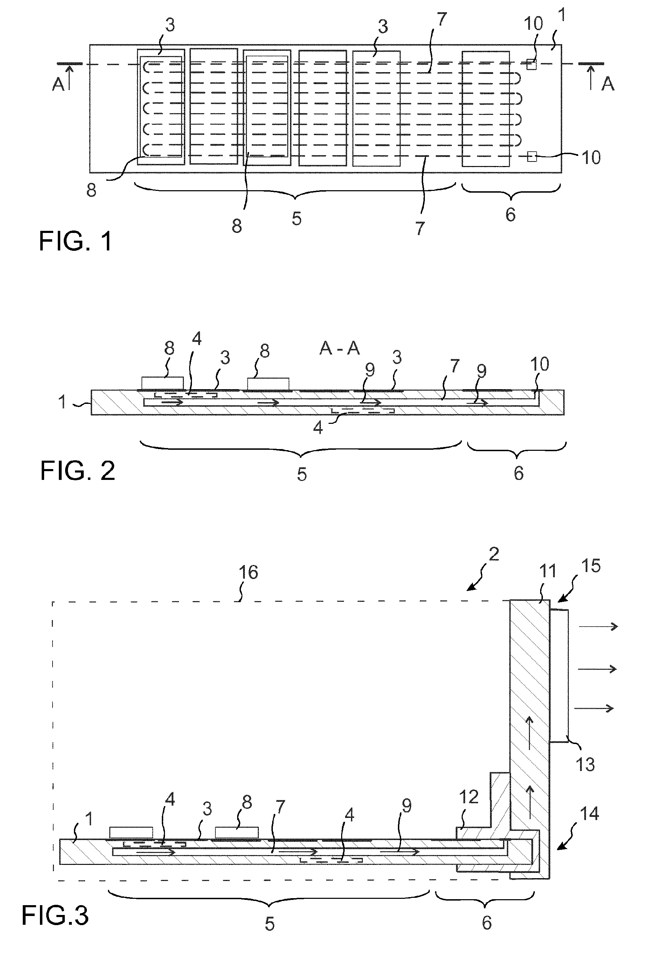

Figures 1 to 3 illustrate a first embodiment of an electric apparatus. Figure 1 illustrates a top view of a circuit board 1, Figure 2 illustrates a cross-section of the circuit board 1 of Figure 1 along line A-A, and Figure 3 illustrates an electric apparatus 2 with the circuit board 1 of Figures 1 and 2.

The circuit board, such as an organic multilayer PCB (Printed Circuit Board) or PWB (Printed Wiring Board), shown in Figures 1 and 2 comprises a plurality of component areas 3 for receiving one or more electric components 8 which may be surface mounted onto the circuit board. Alternatively or additionally, the circuit board 1 may have one or more electric components 4 embedded into the circuit board. Preferably, each electric component of the circuit board is arranged in an evaporator section 5, which is located in the left end of the circuit board in Figures 1 and 2.

In this embodiment the circuit board 1 is also provided with a condenser section 6, which is located in the right end of the circuit board 1 in Figures 1 and 2. The circuit board 1 also comprises a fluid channel for passing a fluid between the evaporator section 5 and the condenser section 6. Heat generated by the one or more electric components 4 or 8 is passed at the evaporator section 5 into the fluid in the fluid channel 7, and further on via the fluid to the condenser section 6, as illustrated by arrows 9.

In the embodiment according to Figures 1 to 3 it is by way of example assumed that the fluid channel 7 is a part of a heat pipe. One alternative is that the heat pipe is a pulsating heat pipe integrated into the circuit board 1.

In this example the fluid channel 7 of the PHP (Pulsating Heat Pipe) consists of a meandering tube of capillary dimensions with many U-turns, as best seen in Figure 1. In contrast to a conventional heat pipe, an additional capillary structure inside the tube is not necessary. There are two ways to arrange the tube: open loop and closed loop. As the names suggest, in a closed loop structure, the tube is joined end-to-end. Figure 1 illustrates an open loop, where the ends 10 of the tube can be reached via an upper surface of the circuit board 1.

The tube is first evacuated and then filled partially with a working fluid, which distributes itself naturally in the form of liquid-vapour plugs and slugs inside the capillary tube. One end of this tube bundle (evaporator section 5) receives heat, transferring it to the condenser section 6 by a pulsating action of the liquid-vapour/bubble-slug system. There may exist an optional adiabatic zone in between. A PHP is essentially a non-equilibrium heat transfer device. The performance success of the device primarily depends on the continuous sustenance of non-equilibrium conditions within the system. One alternative for maintaining this non-equilibrium condition are continuous heat losses from electric components 4 and 8 during operation and the rejection of heat from the circuit board via the condense section.

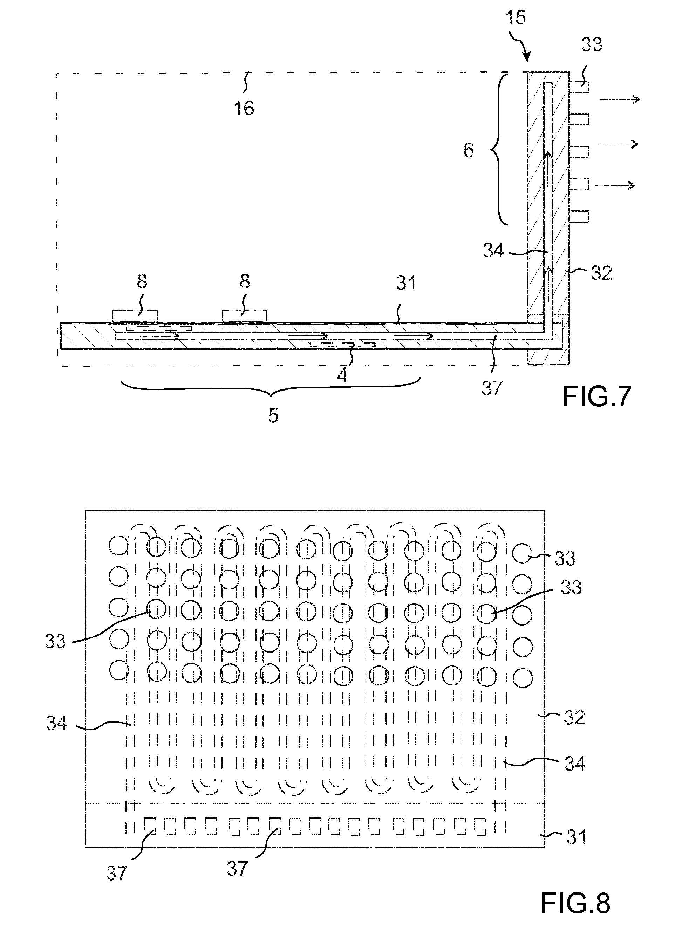

Figure 3 illustrates the circuit board 1 of Figures 1 and 2 once it has been thermally connected to a cooling element 11 via the condenser section 6 of the circuit board. In this embodiment the evaporator section 5 and condenser section 6 are both located in the circuit board 1, which means that the fluid channel 7 does not extend into the cooling element 11 (though it could similarly as will be later explained in connection with Figures 7 and 8). Instead the circuit board 1 is mechanically and thermally attached to a proximal end 14 of the cooling element 11 by an interface part 12, which may be manufactured of a material having excellent heat conducting properties. One alternative is to utilize a polymer for the interface part 12.

Heat conducted from the circuit board 1 to the cooling element 11 is conducted from the proximal end 14 of the cooling element to fins 13 or pin fins that dissipate the heat load into the surroundings from the distal end 15 of the cooling element 11, in praxis into the surrounding air.

The cooling element 11 may be arranged inside an enclosure or a housing of the electric apparatus, in which case the heat load is released into the air inside of the enclosure. In that case an additional arrangement may be needed in order to remove heat from within the enclosure 16 to the outside of the enclosure.

In Figure 3 it is, however, by way of example assumed that the cooling element 11 consists of a part of the enclosure 16. In the illustrated example the cooling element 11 consists of a outer wall of the practically air-tight enclosure 16, though as an alternative the cooling element may consist of a roof or a bottom of the enclosure (or of a part of a wall, bottom or roof of the enclosure). In this way, by thermally attaching the circuit board 1 to a part of the enclosure, this part of the enclosure can dissipate the heat load to the surroundings without a need for an additional separate cooling element. Preferably, the part of the enclosure 16 working as the cooling element 11 is manufactured of a material with excellent heat conducting properties, such as of a metallic (aluminum, for instance) or plastic material. An arrangement of this type is very useful in an environment where the electric apparatus needs to be utilized in a dirty or wet environment, as it facilities easy and efficient cooling without a need for openings in the enclosure 16. Such an arrangement may be used in an electric apparatus consisting of a part of a motor drive for controlling supply of electricity to an electric motor, for instance.

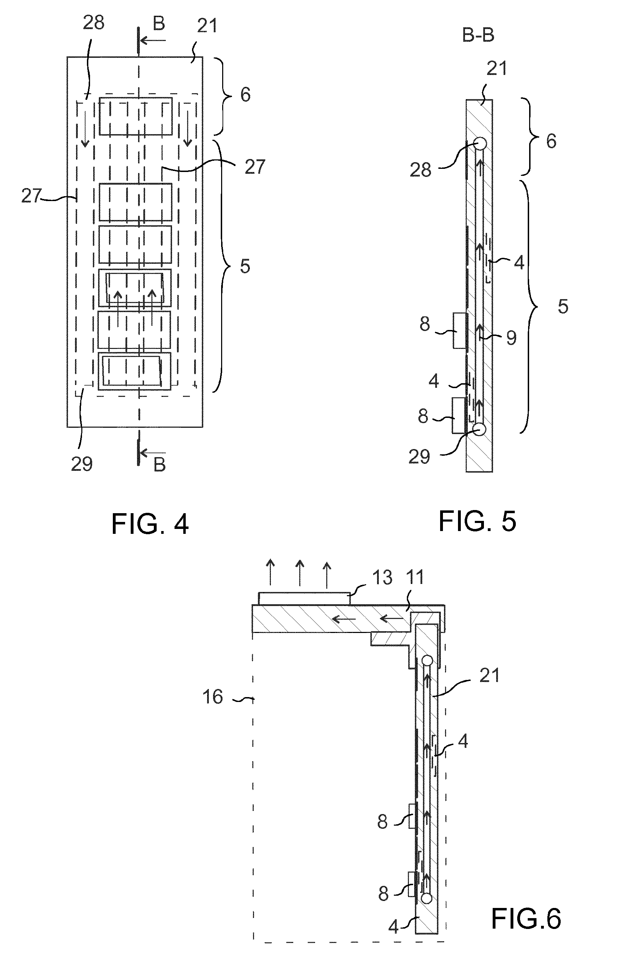

Figures 4 to 6 illustrate a second embodiment of an electric apparatus. The apparatus of Figure 4 to 6 is very similar as the one explained in connection with Figures 1 to 3. Therefore, in the following the embodiment of Figures 4 to 6 will be mainly explained by pointing out the differences between these embodiments.

In the embodiment of Figures 4 to 6 the fluid channel 27 is not a part of a heat pipe, but instead a part of a thermosyphon which passes the heat load from the evaporator section 5 to the condenser section 6, as indicated by arrows 9.

In the case of the thermosyphon, the heat originating from the electric components 4 and 8 is passed to the fluid at the evaporator section 5. The evaporated vapour phase fluid rises in the channel to the condenser section 6 where it condenses back to a liquid phase. In the embodiment of Figures 4 to 6 it is by way of example assumed that the fluid channel 27 in the circuit board includes a plurality of parallel channels. The channels in the middle of the circuit board 21 (Figure 4) pass vapour upwards to a manifold 28, and the channels at the edges of the circuit board 21 (Figure 4) return condensed and liquid to a bottom manifold 29 from where the fluid again enters the channels in the middle of the circuit board. Consequently, fluid circulation is accomplished due to evaporation (upwards) and gravity (downwards) without a need to utilize a pump to circulate fluid.

As the thermosyphon explained by way of example above operates most efficiently in an upright position, Figure 6 illustrates the circuit board 21 in such an upright position inside an enclosure 16. Also in this embodiment it is by way of example assumed that the cooling element 11 is a part of the enclosure 16. In this example, the roof (or a part of the roof) works as the cooling element 11, which conducts heat from the condenser section 6 of the circuit board 21 via the fins 13 to the surroundings. In some embodiments it may be possible to utilize the circuit board 21 also in other positions, in which case a part of the fluid channel is advantageously of capillary size in order to ensure a fluid flow in a correct direction in those parts of the fluid channel where gravity is incapable of generating a sufficient flow in a desired direction.

Figures 7 to 8 illustrate a third embodiment of an electric apparatus. The apparatus of Figures 7 to 8 is very similar as the one explained in connection with Figures 1 to 3. Therefore, in the following the embodiment of Figures 7 to 8 will be mainly explained by pointing out the differences between these embodiments.

In the embodiment of Figures 7 to 8 the cooling element 32 is provided with a second fluid channel 34 such as a micro channel which is in fluid communication with the fluid channel 37 of the circuit board 31. Heated fluid is therefore passed from the evaporation section 5 of the circuit board 31 to the condenser section 6 which in this embodiment is located in the distal end 15 of the cooling element 32. In the condenser section 6 the heat load is transferred to the surroundings via pin fins 33 (or fins 13 as in the previous embodiments). The cooling element 32 may be located within an enclosure or alternatively it may consist of a part (such as a wall or a part of a wall) of an air-tight enclosure 16, as explained in the previous embodiments.

In the embodiment of Figures 7 and 8 it is by way of example assumed that the fluid channel 37 of the circuit board 31 and the second fluid channel of the cooling element 32 are both a part of a heat pipe, such as a closed-loop pulsating heat pipe. From Figure 8 it can be seen that the second fluid channel 34 of the cooling element 32 makes several U turns within the cooling element 32 and that the ends of the second fluid channel 34 are connected to the ends of the fluid channel 37 of the circuit board 31 in the lower part of the cooling element 32. The fluid channel 37 of the circuit board may be arranged similarly as has been illustrated in Figure 1, and the ends 10 of the fluid channel 7 of Figure 1 are connected to the ends of the second fluid channel 34 of the cooling element, in order to obtain one single closed pulsating heat pipe (instead of an open pulsating heat pipe as in Figure 1).

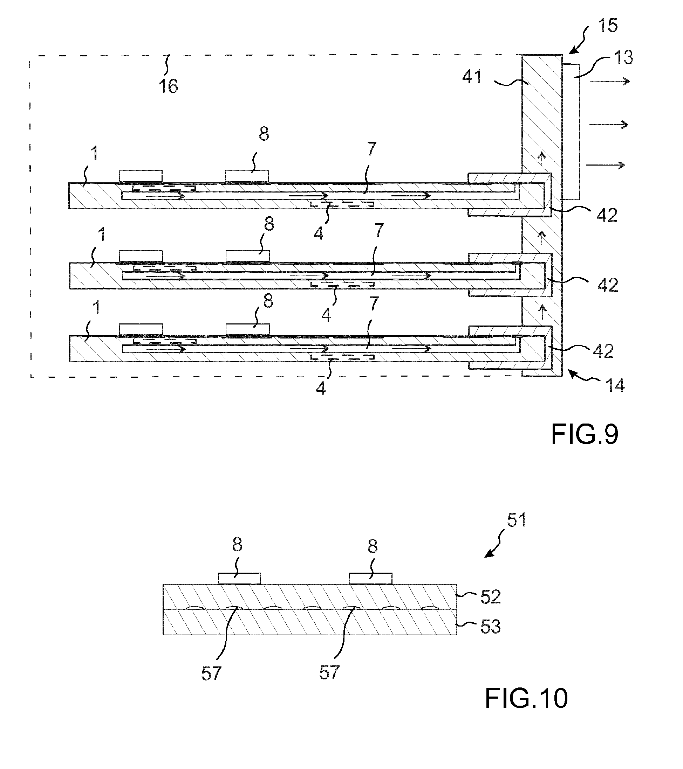

Figure 9 illustrates a fourth embodiment of an electric apparatus. The apparatus of Figure 9 is very similar as the one explained in connection with Figures 1 to 3. Therefore, in the following the embodiment of Figure 1 will be mainly explained by pointing out the differences between these embodiments.

In Figure 9 the electric apparatus comprises a circuit board 1 similar as the one illustrated in Figure 3 arranged in proximity of the proximal end 14 of the cooling element 41, which by way of example is assumed to be a part of an enclosure 16, such as a wall of the enclosure 16. This circuit board 1 is thermally connected to the cooling element 41 via an interface part 42 conducting heat from the condenser section of the circuit board to the cooling element 41, which heat is dissipated from the cooling element via fins 13.

In the embodiment of Figure 9, however, there is also a second circuit board 1 and a third circuit board 1, similar as the lowest circuit board 1, and similarly thermally and mechanically attached to the cooling element 41 as the lowest circuit board 1 in a rack configuration. Each circuit board 1 has a flow channel 7 and a respective evaporator section and condenser section, such that heat generated by the electric components 4 and 8 of the circuit boards is passed on via the same cooling element 41 and the fins 13 to the surroundings of the enclosure 16.

The fluid channels 7 of the circuit boards of Figure 9 may be a part of a heat pipe, as in Figure 1 and 7, for instance, or alternatively a part of a thermosyphon as in Figure 4, in which case the circuit boards may be arranged in an upright position.

Figure 10 illustrates manufacturing of a circuit board. Figure 10 illustrates a cross section of a circuit board 51 such that the pipes of the fluid channel 57 are visible. In this example the circuit board consists of two different plates attached to each other. In the illustrated example the pipes of the fluid channel 57 have been manufactured in the surface of the upper plate 52 that is facing the lower plate, 53 while the lower plate 53 has a smooth surface facing the upper plate. In this position the plates are attached to each other such that the pipes of the fluid channel 57 are embedded or integrated into the material of the circuit board 51.

In Figure 10 at least one of the plates 52 and 53 is manufactured of a material suitable for use in a circuit board, such that the fluid in the fluid channel is in direct contact with the circuit board material. This ensures a direct and efficient cooling of the circuit board material.

In the drawings it has by way of example been illustrated that the cooling element extends mainly perpendicularly from the circuit board. This is, however, only by way of example. Instead it is possible that the cooling element is arranged as an extension of the circuit board, in parallel with the circuit board on top or below the circuit board, or to extend in any other angle from the circuit board. In each case a material with excellent thermal conductivity is arranged at the condenser section (at the circuit board or cooling element). Such a material may be a polymer material or a metal material, such as aluminum.

It is to be understood that the above description and the accompanying figures are only intended to illustrate the present invention. It will be obvious to a person skilled in the art that the invention can be varied and modified without departing from the scope of the invention.

## Claims

1. An electric apparatus, comprising:
a circuit board (1, 21, 31, 51), and
a cooling element (11, 32, 41) for dissipating heat, **characterized in that**
the circuit board (1, 21, 31, 51) comprises a fluid channel (7, 27, 37, 57) for passing fluid to a condenser section (6) which is thermally connected to the cooling element (11, 21, 32, 41), and
the circuit board (1, 21, 31, 51) comprises an evaporator section (5) for receiving a heat load from one or more electric components (4, 8) and for passing the heat load to a fluid in the fluid channel (7, 27, 37, 57).

2. The apparatus according to claim 1, **characterized in that**
the fluid channel (7, 27, 37, 57) passes fluid between the evaporator section (5) and the condenser section (6) of the circuit board (1, 21), and
the condenser section (6) is thermally connected to the cooling element (11, 41) for conducting heat from the fluid to the cooling element.

3. The apparatus according to claim 1, **characterized in that**
the condenser section (6) is arranged in the cooling element (32),
the cooling element (32) comprises a second fluid channel (34), and
the fluid channel (37) of the circuit board and the second fluid channel (34) of the cooling element (32) pass fluid between the evaporator section (5) of the circuit board (31) and the condenser section (6) of the cooling element (32).

4. The apparatus according to one of claims 1 to 3, **characterized in that** the cooling element (11, 32, 41) comprises a proximal end (14) thermally connecting the cooling element to the circuit board (1, 21, 31, 51) and a distal end (15) which is provided by fins (13) or protrusions (33) for dissipating heat from the cooling element to the surroundings.

5. The apparatus according to one of claims 1 to 4, **characterized in that** the circuit board (1, 21, 31, 51) comprises at least one embedded electric component (4).

6. The apparatus according to one of claims 1 to 5, **characterized in that** the electric apparatus comprises a second circuit board with a fluid channel (7) for passing fluid to a condenser section (6) which is thermally connected to the cooling element (41), and with an evaporator section (5) for receiving a heat load from one or more electric components (4, 8) and for passing the heat load to a fluid in the fluid channel.

7. The apparatus according to one of claims 1 to 6, **characterized in that** the fluid channel (7, 37, 57) of the circuit board is a part of a heat pipe passing the heat load from the evaporator section (5) to the condenser section (6).

8. The apparatus according to claim 7, **characterized in that** said heat pipe is a pulsating heat pipe.

9. The apparatus according to one of claims 1 to 6, **characterized in that** the fluid channel (27) is a part of a thermosyphon passing the heat load from the evaporator section (5) to the condenser section (6).

10. The apparatus according to one of claims 1 to 9, **characterized in that**
the apparatus comprises an enclosure (16) enclosing the circuit board (1, 21, 31, 51),
the cooling element (11, 32, 41) consists of a part of the enclosure (16), and
the circuit board (1, 21, 31, 51) is thermally connected to the enclosure for passing heat from the circuit board to the enclosure.

11. The apparatus according to one of clams 1 to 10, **characterized in that** the apparatus is a part of a motor drive for controlling supply of electricity to an electric motor.
